(19) Europäisches Patentamt / European Patent Office / Office européen des brevets

(11) **EP 1 806 866 A1**

(12) **DEMANDE DE BREVET EUROPEEN**

(43) Date de publication:
**11.07.2007 Bulletin 2007/28**

(51) Int Cl.:
***H04L 1/00*** *(2006.01)*

(21) Numéro de dépôt: **07290011.1**

(22) Date de dépôt: **04.01.2007**

(84) Etats contractants désignés:
**AT BE BG CH CY CZ DE DK EE ES FI FR GB GR HU IE IS IT LI LT LU LV MC NL PL PT RO SE SI SK TR**
Etats d'extension désignés:
**AL BA HR MK YU**

(30) Priorité: **05.01.2006 FR 0600080**

(71) Demandeur: **ETAT-FRANCAIS représenté par le Délégué Général pour l' Armement 94114 Arcueil Cedex (FR)**

(72) Inventeurs:
• **Barbier, Johann 35580 Guichen (FR)**
• **Caillard, Paul-Emmanuel 35000 Rennes (FR)**

(54) **Procédés d'émission en de réception de données D ainsi que de données supplémentaires D' et dispositifs associés**

(57) L'invention concerne un procédé et un dispositif associé pour envoyer des données D entre un émetteur et un ou plusieurs récepteurs à travers un canal. Et à plus particulièrement pour objet un procédé de transmission de données D ainsi que de données supplémentaires D', à partir d'un émetteur comportant des moyens de stockage d'information (5) et des moyens de traitement de données (7,9), procédé comportant une étape consistant à appliquer un code correcteur d'erreurs C aux dites données D, caractérisé en ce qu'il comporte une étape consistant à coder les dites données supplémentaires D' par tout ou partie des paramètres du code correcteur d'erreurs C.

Figure 2

EP 1 806 866 A1

## Description

L'invention concerne un procédé et un dispositif associé pour envoyer des données D entre un émetteur et un ou plusieurs récepteurs à travers un canal et a plus particulièrement pour objet un procédé de transmission de données D ainsi que de données supplémentaires D', à partir d'un émetteur comportant des moyens de stockage d'information et des moyens de traitement de données, procédé comportant une étape consistant à appliquer un code correcteur d'erreurs aux dites données D.

En cas de changement du code correcteur utilisé dans un canal de communication, les nouveaux paramètres du code sont habituellement choisis à l'avance et envoyés dans la trame.

Par ailleurs, les codes correcteurs décodés par turbo-décodage sont parmi les codes correcteurs d'erreurs modernes les plus performants. Ils utilisent des codes convolutifs et une permutation fixée ou pseudo aléatoire, que l'émetteur et le récepteur doivent tous deux connaître. La notification du changement de paramètres se fait par l'envoie d'un message de signalisation.

Un premier objectif de l'invention est de résoudre cet inconvénient en proposant un procédé de transmission d'information dans lequel la notification du changement de paramètres se fait sans envoi d'un message de signalisation dédié et sans débit supplémentaire sur le canal de données ni utilisation de bande passante supplémentaire. Un deuxième objectif de l'invention est de pouvoir envoyer à tout moment des informations urgentes ou importantes d'un émetteur à un récepteur, sans que cela perturbe le reste de la communication entre eux.

La solution apportée est un procédé de transmission de données D ainsi que de données supplémentaires D', à partir d'un émetteur comportant des moyens de stockage d'information et des moyens de traitement de données, procédé comportant une étape consistant à appliquer un code correcteur d'erreurs C aux dites données D, caractérisé en ce qu'il comporte une étape consistant à coder les dites données supplémentaires D' par tout ou partie des paramètres du code correcteur d'erreurs C.

Selon une caractéristique particulière, il comporte une étape consistant à changer le code correcteur d'erreurs appliqué aux dites données D, les paramètres du nouveau code correcteur d'erreurs étant représentatifs desdites données supplémentaires D'.

Le code correcteur d'erreurs peut par exemple être un turbo-code constitué de deux codes convolutifs C1 et C2 et d'une permutation P, les dites données D' étant codées par les paramètres de C1 et/ou de C2 et/ou de P.

L'invention concerne aussi un dispositif de transmission de données D ainsi que de données supplémentaires D', apte à mettre en oeuvre un procédé selon l'invention et comportant des moyens de stockage d'information et des moyens de traitement de données aptes à générer les paramètres d'au moins un code correcteur d'erreurs, ces moyens de traitement étant aptes à coder les dites données supplémentaires D' par tout ou partie des paramètres du code correcteur d'erreurs.

L'invention concerne par ailleurs un procédé de réception de données D ainsi que de données supplémentaires D' émises selon un procédé de transmission selon l'invention et caractérisé en ce qu'il comporte une étape de détection d'un éventuel changement de code correcteur d'erreurs, mettant par exemple en oeuvre un distingueur. En cas de détection d'un changement de code correcteur d'erreurs, il peut comporter une étape de détermination des nouveaux paramètres du code correcteur d'erreurs et, préférentiellement une étape complémentaire consistant à déterminer les dites données supplémentaires D' à partir desdits nouveaux paramètres du code correcteur d'erreurs et d'un dictionnaire des paramètres autorisés et des informations codées correspondantes, ces informations codées correspondant aux dites données supplémentaires D'.

L'invention concerne aussi un dispositif de réception de données D ainsi que de données supplémentaires D', apte à mettre en oeuvre un procédé selon l'une quelconque des revendications et comportant des moyens de stockage d'information et des moyens de traitement de données, caractérisé en ce que ces moyens de traitement sont aptes à détecter un changement de code correcteur d'erreurs, à déterminer les paramètres du nouveau code correcteur d'erreurs et à en déduire les dites données supplémentaires D'.

L'information envoyée à travers les paramètres du code correcteur d'erreurs peut être utilisée pour plusieurs applications :

Elle permet d'envoyer à tout moment des informations urgentes ou importantes au récepteur, sans que cela perturbe le reste de la communication. Dès le début de réception

de ces informations, le récepteur en aura connaissance sans avoir besoin d'opérations ou d'attentes supplémentaires.

Dans le cas d'un système de communication bidirectionnel entre deux équipements, l'invention permet de faire l'adaptation au canal de transmission, sans surdébit sur le canal de données : l'asservissement de l'adaptation au canal ne coûte donc rien en bande passante.

Dans le cas d'utilisation d'un code correcteur dont on possède un algorithme partiel ou complet de reconstruction, il est possible d'envoyer de l'information codée dans les paramètres à reconstruire du code. Cela permet donc d'augmenter le rendement du code, sans nuire à ses performances. En revanche, pendant la durée nécessaire pour retrouver les paramètres du code, les données transmises dans le canal ne peuvent pas être décodées. Elles seront stockées puis décodées après coup : l'augmentation du rendement a pour contrepartie une augmentation de la durée de décodage, et n'est donc pas adaptée à tous les types de communications. L'augmentation de la durée de décodage dépend directement de la quantité d'information codée dans les paramètres à reconstruire du code correcteur d'erreurs.

L'invention concerne un procédé et dispositif associé de transmission de l'information à travers les paramètres d'un code correcteur d'erreurs utilisé dans un canal de communication, le procédé global comprenant les étapes suivantes :

E1: Génération des paramètres du nouveau code correcteur d'erreurs, contenant l'information à transmettre.

E2 : Changement du codage correcteur dans l'émetteur.

E3 : Détection du changement de code correcteur et détermination des nouveaux paramètres.

E4 : Exploitation de l'information contenue dans les nouveaux paramètres et décodage du flux de données.

Le flux de données correspond aux informations envoyées codées par le code correcteur d'erreurs.

Le flux caché correspond aux informations codées dans les nouveaux paramètres du codage correcteur d'erreurs.

Pour faire fonctionner le procédé de l'invention, il faut disposer :

- d'un algorithme de détection de changement de paramètres du code correcteur d'erreurs utilisé,
- d'un algorithme qui permet de retrouver les paramètres du code correcteur d'erreurs utilisé,
- d'un dictionnaire, qui associe à une liste de paramètres autorisés du code correcteur une valeur pour le flux caché.

Au cours de l'étape E1 de génération des paramètres du nouveau code correcteur d'erreurs, l'information à transmettre dans le flux caché est codée par le choix des paramètres du nouveau code correcteur d'erreur ou de la permutation utilisée. Le nombre de bits qu'il est possible de transmettre dans le canal caché dépend du type de code utilisé, de la vitesse à laquelle on veut que le récepteur retrouve les paramètres, et de la durée d'émission minimum avec le même code. Cette étape est effectuée à chaque changement de code correcteur d'erreurs. Au cours de l'étape E2, le code correcteur utilisé est changé, utilisant les nouveaux paramètres déterminés à l'étape El. Le signal est alors modulé par l'émetteur et envoyé dans le canal.

Au cours de l'étape E3, le récepteur démodule le signal envoyé par l'émetteur à l'étape E2 et détecte s'il y a eu changement de code correcteur utilisé grâce à l'algorithme de détection. Le récepteur retrouve ensuite les paramètres du nouveau code correcteur à l'aide de l'algorithme de reconstruction des paramètres et du dictionnaire des différents paramètres autorisés.

Au cours de l'étape E4, le récepteur déduit des paramètres retrouvés à l'étape E3 et du dictionnaire des paramètres autorisés, la valeur du flux caché associée au paramètre du nouveau code correcteur d'erreurs. Le récepteur décode aussi le flux de données avec les nouveaux paramètres du code correcteur d'erreurs, à partir du premier symbole ayant subi le changement de code correcteur d'erreurs.

L'invention et les avantages qui en découlent apparaîtront plus clairement à la lecture de la description qui suit. Un premier exemple de mise en oeuvre concerne un système de communication permettant d'envoyer à tout moment des informations urgentes ou importantes au récepteur, sans que cela perturbe le reste de la communication. Plusieurs variantes du procédé d'envoi d'information à travers les paramètres du code correcteur d'erreurs seront ensuite données. La description est à lire en référence aux dessins annexés dans lesquels :

- la figure 1 est un schéma d'un dispositif global apte à mettre en oeuvre l'invention, dispositifs dans lesquels est implémenté le procédé de l'invention,
- la figure 2 présente un dispositif d'émission selon l'invention,
- la figure 3 présente un dispositif de réception selon l'invention,

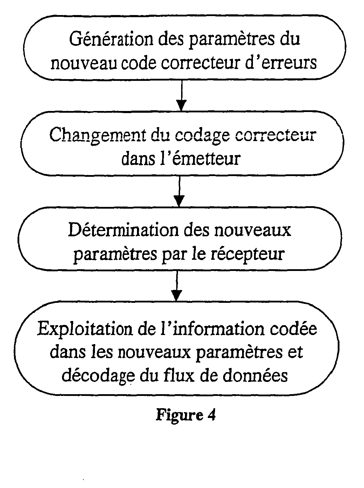

- la figure 4 est un diagramme d'un procédé selon l'invention.

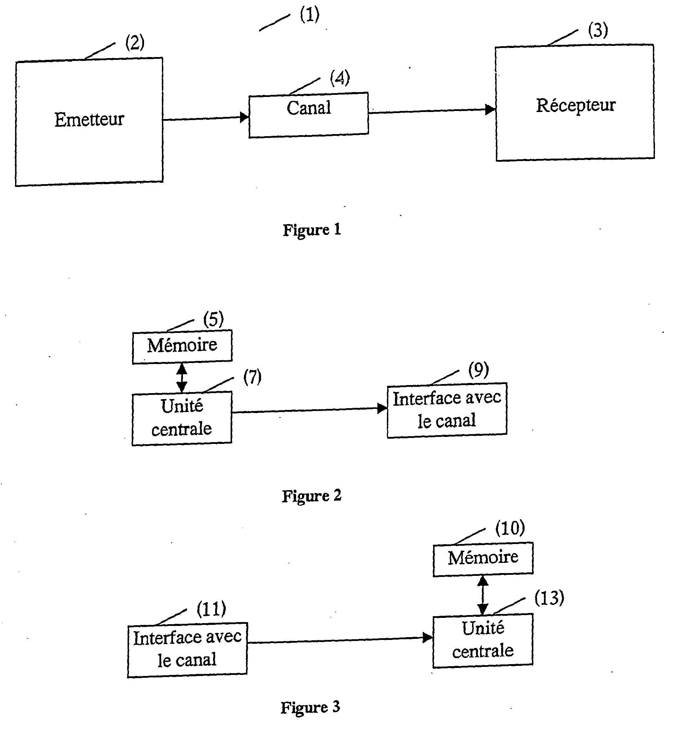

La figure 1 représente sous forme de schéma bloc d'un dispositif électronique de télécommunication (1) apte à mettre en oeuvre un procédé de codage et transmission de l'information selon l'invention. Dans l'exemple, le dispositif (1) contient deux équipements, l'équipement émetteur (2) et l'équipement récepteur (3) reliés par un canal de transmission (4).

La figure 2 représente sous forme de schéma bloc la réalisation de l'émetteur (2). L'émetteur est un équipement électronique, contenant des moyens de calculs programmés. L'émetteur comprend une unité centrale (7), capable d'effectuer des opérations de calculs programmés. Elle est reliée à une ou plusieurs mémoires (5). Les données à diffuser au récepteur sont contenues dans la mémoire (5) de l'émetteur. L'unité centrale (7) génère selon le procédé de l'invention les bits à transmettre, y compris les bits de redondances du code correcteur d'erreur, à l'aide de la mémoire (5). L'unité centrale (7) est aussi reliée à un modulateur (8), qui transforme les bits à transmettre en symboles. Le modulateur (8) envoie les symboles qu'il génère au bloc d'interface avec le canal (9) avec lequel il est relié. Le bloc d'interface avec le canal (9) est chargé d'envoyer les symboles à travers le canal.

L'invention peut être mise en place pour n'importe quel type de canal (4) de Communication, hertzien, satellite, fibre optique, paire de cuivre, câble coaxial, courant porteur ou autre. Le canal peut avoir n'importe quelle caractéristique (canal AWGN, canal de Rayleigh,...)

La figure 3 représente sous forme de schéma bloc la réalisation du récepteur (3). Le récepteur est un équipement électronique, contenant des moyens de calculs programmés. Le récepteur contient un bloc interface avec le canal (11) relié au canal (3), qui reçoit et traite les données contenues dans le canal et envoyées par l'émetteur. Ce bloc (11) envoie à l'unité centrale les symboles qu'il reçoit, c'est à dire les symboles envoyés par l'émetteur modifiés par les perturbations introduites dans le canal. L'unité centrale (13), capable de faire des calculs programmés, est reliée à une ou plusieurs mémoires (10). L'unité centrale (13) retrouve le code correcteur d'erreurs et en déduit les informations envoyées dans le flux caché selon le procédé de l'invention. L'unité centrale (13) décode ensuite le flux de données avec les nouveaux paramètres du code correcteur d'erreurs.

Au cours de l'étape E1, l'unité centrale (7) de l'émetteur détermine le nouveau code correcteur d'erreurs à utiliser en fonction de l'information à envoyer dans le flux caché et du dictionnaire qui associe à une liste de paramètres autorisés du code correcteur une valeur pour le flux caché. Dans notre exemple de réalisation, les informations du flux caché peuvent être codées par le choix d'un code convolutif de rendement 1/2 et de longueur de contrainte 8. A chaque codeur est associée une information différente.

Au cours de l'étape E2, le code correcteur utilisé dans le modulateur est modifié, et le nouveau flux de données est envoyé dans le canal par l'émetteur, codé avec le nouveau code correcteur d'erreurs.

Au cours de l'étape E3, le récepteur détecte si le code correcteur utilisé est le code courrant ou un nouveau code. Pour faire cette détection il utilise un distingueur selon la méthode suivante :

- Dans la représentation algébrique, notons $f_1(x)$ et $f_2(x)$ les deux polynômes du codeur,

$c_1(x)$ et $c_2(x)$ les deux séries représentant les pistes du flux de données. Les $f_i(x)$ et $c_i(x)$ vérifient l'équation suivante :

$$f_1(x)c_2(x)+f_2(x)c_1(x)=0$$

Cette équation est vérifiée tout au long de la transmission sauf éventuellement un petit nombre de fois dépendant de l'erreur introduite par le canal de transmission. Si l'on teste cette relation avec d'autres polynômes (ie avec d'autres codeurs), celle-ci est vérifiée en moyenne une fois sur deux, ce qui permet de distinguer le codeur utilisé des autres codeurs. Ce distingueur peut se généraliser pour des codeurs convolutifs quelconques de rendement k/n et de longueur de contrainte m+1.

Au cours de l'étape E4, le récepteur déduit des paramètres retrouvés à l'étape E3 et du dictionnaire des paramètres autorisés, la valeur du flux caché associée au paramètre du nouveau code correcteur d'erreurs. Le récepteur décode aussi le flux de données avec les nouveaux paramètres du code correcteur d'erreurs, à partir du premier symbole ayant subi le changement de code correcteur d'erreurs.

Selon une première variante de réalisation, l'invention permet d'adapter le code correcteur d'erreur au canal sans avoir besoin d'envoyer des informations dans le flux de données. Dans cette variante, chaque équipement, A et B, du dispositif est à la fois émetteur et récepteur. Le code correcteur utilisé sur chaque canal, 1 et 2, est asservi aux changements du canal, pour toujours offrir le débit maximal. Considérons que la qualité des canaux (lié à son bruit, aux réflexions, ...) contiennent N états possibles. A chaque état des canaux 1 et 2, correspond un code correcteur d'erreurs $C_1$ (respectivement $C_2$) adapté au canal 1 (resp. 2) et codant l'état du canal 2 (resp. 1). Nous supposons que chaque équipement est capable d'évaluer l'état du canal sur lequel il reçoit de l'information, à condition que l'autre équipement envoie de l'information sur le canal. Nous noterons par la suite $C_j^i$ le code correcteur d'erreurs associé aux états des canaux, adapté au canal j, à l'étape i du protocole.

L'adaptation du codage correcteur au canal s'effectue suivant le protocole suivant : Initialisation : A et B n'ont qu'une connaissance *a priori* des canaux 1 et 2. $C_1^0$ et $C_2^0$ sont initialisés par cette connaissance.

A l'étape i :

1. A reçoit le flux de données de B
2. A retrouve les $C_2^{i-1}$ en utilisant un distingueur ou un algorithme de reconstruction et en déduit l'état du canal 1
3. A décode le flux de données
4. A évalue le l'état du canal 2
5. A code le flux de données avec $C_1^i$ correspondant aux états des canaux 1 et 2 et envoie le flux à B.
6. B effectue les étapes 1-5 avec le flux de données codé par $C_1^i$

Chaque équipement adapte ainsi son codage correcteur d'erreurs à la qualité du canal sur lequel il émet, de manière dynamique. Cette technique est adaptée aux canaux dont les caractéristiques ont des variations lentes par rapport au temps aller-retour entre les deux équipements : sinon l'asservissement ne peut pas suivre les variations du canal.

Selon une seconde variante de réalisation, l'invention permet d'augmenter le rendement d'une famille de code correcteur d'erreurs permettant la mise en oeuvre d'un algorithme de reconstruction ou d'un distingueur sur toute ou partie du codeur. Le choix des paramètres du code correcteur code de l'information supplémentaire. Un turbo-code consistant en deux codes convolutifs C1 et C2 et en une permutation permet de coder les informations complémentaires à transmettre par les paramètres de C1 et/ou C2 et/ou P. Par exemple le choix d'une permutation P dans un turbo-codeur permet de coder au

plus log$_2$ (N!) bits d'information supplémentaire. Chaque nouvelle permutation donne un turbo-code différent et apporte de l'information supplémentaire. Un algorithme de reconstruction de permutation est donné dans le poster J. Barbier et V. Camion Reconstruction de Permutation, Majecstic'03, octobre 2003, Marseille. L'émetteur code le flux de données D avec le code correcteur dont le choix des paramètres correspond à l'information supplémentaire D' à transmettre. Le récepteur reçoit le flux de données, retrouve les paramètres du code correcteur qu'il ne connaît pas, par un algorithme de reconstruction ou un distingueur, et en déduit l'information supplémentaire D'. Avec ces paramètres, il peut décoder le flux de données D. Au final, le récepteur aura reçu les données D plus l'information supplémentaire D'. La quantité d'information supplémentaire que l'on peut transmettre dépend du procédé de reconstruction ou du distingueur.

**Revendications**

1. Procédé de transmission de données D ainsi que de données supplémentaires D', à partir d'un émetteur comportant des moyens de stockage d'information (5) et des moyens de traitement de données (7,9), procédé comportant une étape consistant à appliquer un code correcteur d'erreurs C aux dites données D, **caractérisé en ce qu'**il comporte une étape consistant à coder les dites données supplémentaires D' par tout ou partie des paramètres du code correcteur d'erreurs C.

2. Procédé de transmission de données D ainsi que de données supplémentaires D' selon la revendication 1, **caractérisé en ce qu'**il comporte une étape consistant à changer le code correcteur d'erreurs appliqué aux dites données D, les paramètres du nouveau code correcteur d'erreurs étant représentatifs desdites données supplémentaires D'.

3. Procédé de transmission de données D ainsi que de données supplémentaires D' selon l'une quelconque des revendications 1 et 2, **caractérisé en ce que** ledit code correcteur d'erreurs est un turbo-code.

4. Procédé de transmission de données D ainsi que de données supplémentaires D' selon la revendication 3, **caractérisé en ce que** le turbo-code est constitué de deux codes convolutifs C1 et C2 et d'une permutation P et **en ce que** les dites données D' sont codées par les paramètres de C1 et/ou de C2 et/ou de P.

5. Dispositif de transmission de données D ainsi que de données supplémentaires D', apte à mettre en oeuvre un procédé selon l'une quelconque des revendications 1 à 4, et comportant des moyens de stockage d'information (5) et des moyens de traitement (7,9) de données aptes à générer les paramètres d'au moins un code correcteur d'erreurs, **caractérisé en ce que** ces moyens de traitement sont aptes à coder les dites données supplémentaires D' par tout ou partie des paramètres d'un code correcteur d'erreurs.

6. Procédé de réception de données D ainsi que de données supplémentaires D' émises selon un procédé de transmission selon l'une quelconque des revendications 1 à 4, **caractérisé en ce qu'**il comporte une étape de détection d'un éventuel changement de code correcteur d'erreurs, une étape de détermination des nouveaux paramètres du code correcteur d'erreurs en cas de détection d'un changement de code correcteur d'erreurs, une étape complémentaire consistant à déterminer les dites données supplémentaires D' à partir desdits nouveaux paramètres du code correcteur d'erreurs et d'un dictionnaire des paramètres autorisés et des informations codées correspondantes, ces informations codées correspondant aux dites données supplémentaires D'.

7. Procédé de réception de données D ainsi que de données supplémentaires D' selon la revendication 6, **caractérisé en ce qu'**il met en oeuvre un distingueur.

8. Procédé de réception de données D ainsi que de données supplémentaires D' selon la revendication 7, **caractérisé en ce que** d'une part le code correcteur d'erreurs est un code convolutif de rendement ½ et d'autre part il met en oeuvre un distingueur selon la méthode suivante : *soit* f$_1$ (x) et f$_2$(x) les deux polynômes du codeur et c$_1$ (x) et c$_2$ (x) les deux séries représentant les pistes du flux de données, les f$_i$ (x) et c$_i$(x) vérifient l'équation suivante :

$$f_1(x)c_2(x)+f_2(x)c_1(x)=0$$

Cette équation étant, pour un même code correcteur d'erreurs, vérifiée tout au long de la transmission, sauf éventuellement un petit nombre de fois dépendant de l'erreur introduite par le canal de transmission.

9. Dispositif de réception de données D ainsi que de données supplémentaires D', apte à mettre en oeuvre un procédé selon l'une quelconque des revendications 6 à 8, et comportant des moyens de stockage d'information (10) et des moyens de traitement de données (11, 13), **caractérisé en ce que** ces moyens de traitement sont aptes à détecter un changement de code correcteur d'erreurs, à déterminer les paramètres du nouveau code correcteur

**EP 1 806 866 A1**

d'erreurs et à en déduire les dites données supplémentaires D'.

**Figure 1**

**Figure 2**

**Figure 3**

Génération des paramètres du
nouveau code correcteur d'erreurs

↓

Changement du codage correcteur
dans l'émetteur

↓

Détermination des nouveaux
paramètres par le récepteur

↓

Exploitation de l'information codée
dans les nouveaux paramètres et
décodage du flux de données

**Figure 4**

**Office européen
des brevets**

**RAPPORT DE RECHERCHE EUROPEENNE**

Numéro de la demande

EP 07 29 0011

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | J. BARBIER: "Reconstruction of turbo-code encoders" DIGITAL WIRELESS COMMUNICATIONS VII AND SPACE COMMUNICATION TECHNOLOGIES, [Online] vol. 5819, juin 2005 (2005-06), pages 463-473, XP002385342 Extrait de l'Internet: URL:http://spiedl.aip.org/getpdf/servlet/GetPDFServlet?filetype=pdf&id=PSISDG005819000001000463000001&idtype=cvips&prog=normal > [extrait le 2006-06-14] * abrégé * * page 463 - page 464 * * page 472 * ----- | 1-9 | INV. H04L1/00 |
| A | US 2002/124174 A1 (EHRMANN-PATIN FREDERIQUE ET AL) 5 septembre 2002 (2002-09-05) * abrégé * * page 1, alinéa 12 - alinéa 13 * * page 2, alinéa 26 - alinéa 35 * ----- | 1-9 | |
| | | | DOMAINES TECHNIQUES RECHERCHES (IPC) |
| | | | H04L H03M |

Le présent rapport a été établi pour toutes les revendications

| Lieu de la recherche | Date d'achèvement de la recherche | Examinateur |
|---|---|---|
| Munich | 28 mars 2007 | Marzenke, Marco |

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons
 
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 07 29 0011

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

28-03-2007

| Document brevet cité au rapport de recherche | Date de publication | Membre(s) de la famille de brevet(s) | Date de publication |
|---|---|---|---|
| US 2002124174 A1 | 05-09-2002 | FR 2819672 A1<br>JP 3592299 B2<br>JP 2002319924 A | 19-07-2002<br>24-11-2004<br>31-10-2002 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **J. BARBIER ; V. CAMION.** *Reconstruction de Permutation,* Octobre 2003